# EUROPEAN PATENT APPLICATION

(11) **EP 1 844 973 A1**
(43) Date of publication of application: **17.10.2007**
(21) Application number: 07251550.5
(22) Date of filing: 11.04.2007
(51) Int. Cl.: B60N 2/00, B60R 21/015

(54) **Noise reduction for flexible sensor material in occupant detection**

(30) Priority: 13.04.2006 US 404569
(71) Applicant: Elesys North America Inc., Suwanee, GA 30024 (US)
(72) Inventor: Morgan, Kelvin I., Suwanee Georgia 30024 (US)
(74) Representative: Palmer, Jonathan R.

(57) **Abstract**

Film material (10) for occupant detection in a vehicle is patterned for noise reduction. Flexible circuit material (10) is used for positioning one or more antennas or sensors (12) for occupant detection within a seat. The flexible circuit material (10) is between the fabric or seat covering material and foam. Holes (11A,11B,11C) in the flexible circuit material (10) may reduce noise caused by the flexible circuit material (10). For occupant detection with antennas and transmitted energy, such as capacitance or electric field sensing, the holes (11A,11B,11C) may reduce noise even when the holes are smaller than the antennas.

## Description

### BACKGROUND

The present invention relates to occupant detection. In particular, a flexible occupant sensor adapted for noise reduction is provided.

Occupant detection may be used in conjunction with sensing a crash for determining whether to activate an airbag. Various occupant detection systems have been proposed, including detection based on ultrasound, infrared, radar, electric field, capacitance, weight or combinations thereof. The occupant detection systems use antennas positioned in various locations within a vehicle, such as within a seat. The antennas are piezoelectric material, conductive materials, or other structures. For example, a conductive textile or flexible metallic electrode is positioned within a seat for capacitive or electric field based detection of an occupant. Yet another example, strain gauges or other associated pressure or load sensors are positioned on flexible circuit material within a base portion of the seat.

The flexible circuit or other film material is subjected to pressure from an occupant or other items placed in the seat. The pressure may cause the film material to buckle or crease. When the pressure is removed or shifts, the film material may pop or make other noise.

### BRIEF SUMMARY

By way of introduction, the preferred embodiments described below include methods, improvements and systems for occupant detection and/or noise reduction. Flexible circuit material is used for positioning one or more antennas or sensors for occupant detection within a seat. The flexible circuit material is positioned between the fabric or seat covering material and foam. Holes in the flexible circuit material may reduce noise caused by the flexible circuit material. For occupant detection with antennas and transmitted energy, such as capacitance or electric field sensing, the holes may reduce noise even when the holes are smaller than the antennas.

In a first aspect, a sensor system is provided for occupant detection. A flexible circuit material has a plurality of apertures. At least one antenna is on the flexible circuit material. An occupant detection circuit connects with the at least on antenna. The occupant detection circuit is operable to detect a presence or characteristic of an occupant in response to transmitted energy.

In a second aspect, a method is provided for noise reduction of film material in a seat for occupant detection. A plurality of through holes is provided in the film material, and a conductive area is provided on the film material. The film material is positioned adjacent to foam material. Seat covering material is positioned adjacent the film material.

In a third aspect, a sensor system for occupant detection has a film material. The film material has a first electrode to be positioned in a vehicle seat. The first electrode has a first area on the film material. An improvement comprises a first hole in the film material where the first hole has a first hole area less than the first area.

The present invention is defined by the following claims, and nothing in this section should be taken as a limitation on those claims. Further aspects and advantages of the invention are discussed below in conjunction with the preferred embodiments and may be later claimed independently or in combination.

### BRIEF DESCRIPTION OF THE DRAWINGS

The components and the figures are not necessarily to scale, emphasis instead being placed upon illustrating the principles of the invention. Moreover, in the figures, like reference numerals designate corresponding parts throughout the different views.

Figure 1 shows one embodiment of a flexible film with sensors;

Figure 2 shows one embodiment of a film for occupant detection in a seat of a vehicle; and

Figure 3 is a flow chart diagram of one embodiment of a method for noise reduction.

### DETAILED DESCRIPTION OF THE DRAWINGS AND PRESENTLY PREFERRED EMBODIMENTS

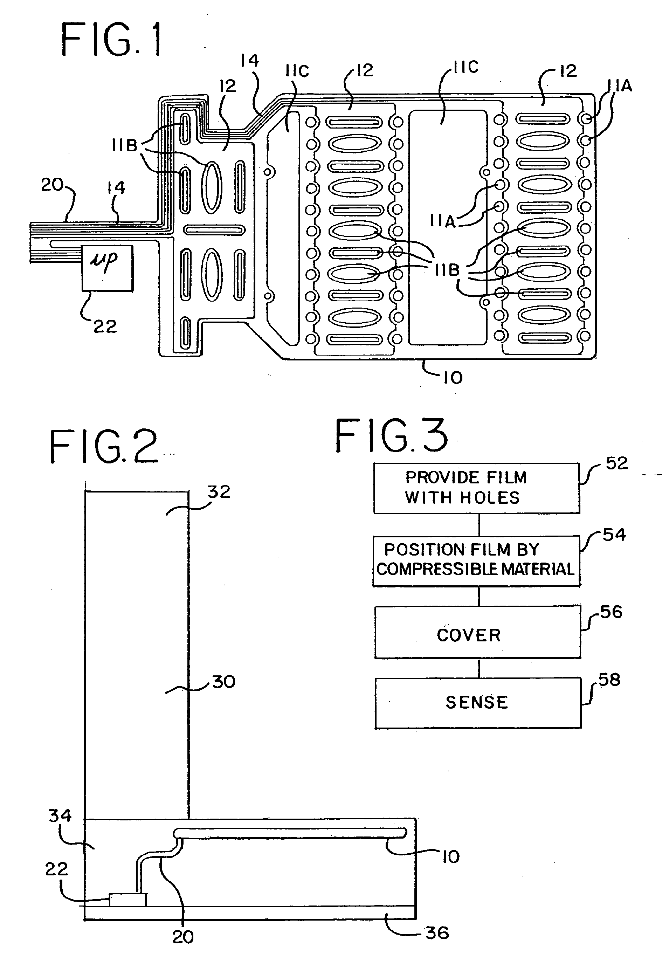

A sensor system for occupant detection includes one or more apertures or holes for noise reduction or other purposes. The sensor system operates in various environments, such as for detecting an occupant within a seat of a vehicle. The sensor system connects with an airbag controller, but may be used for detecting an occupant for other purposes. Figure 1 shows a film material with apertures and electrodes or antennas for occupant detection. Figure 2 shows flexible circuit material with apertures and electrodes or antennas positioned in a seat for occupant detection.

As shown in Figures 1 and 2, the sensor system includes a flexible film 10 of film material. The flexible film 10 is flexible circuit material, such as a Polyimide (Kapton®) film, PET Polyester (Mylar®) film, PEN Polyethylene Napthalate, or other now known or later developed flexible materials for use as a flexible circuit substrate. Other dielectric or non-dielectric films and corresponding material may be used. The flexible circuit material may have active or passive electrical circuit components integrated on the material, or the flexible film 10 is free of active and/passive components.

The flexible film 10 is of any thickness, but is preferably less than 1 cm or even 1 mm thick. In one embodiment, the flexible film 10 is about 18 inches long and 15 inches wide at the widest. Other sizes may be provided.

As shown in Figure 1, the film 10 includes a plurality of apertures 11A-C, sensors 12 and signal traces 14. Additional, different or fewer components may be provided. Any number of sensors 12, such as the three sensors 12 shown or tens or hundreds of sensors 12, may be used. Any number of apertures 11A-C may be used. Any number of types of apertures 11A, 11B, 11C, such as more or less than the three types shown, may be used.

The sensors 12 are conductive material in one or more layers. The sensors 12 are copper, conductive electrodes, strain gauges, pressure sensors, radio frequency antennas, piezoelectric films, semiconductor film based diodes or light detectors, combinations thereof or other now known or later developed sensors for detecting a presence or characteristic of an occupant. The conductive material is formed on the flexible circuit material 10. The conductive material provides electrodes, such as for use as an antenna. The sensors 12 represented in Figure 1 are antennas or electrodes for use with capacitance or electric field based sensing. The sensors 12 are free of active or passive circuit components, but may include such components. Each of the sensors 12 is separate and spaced apart from the other sensors 12. In alternative embodiments, the separate sensors 12 are provided one within the other or overlapping as a function of different sides of the flexible film 10.

The signal traces 14 are isolated from each other for the various sensors 12. The signal traces 14 are of a same or different material as the sensors 12, such as both being deposited, etched or form rolled annealed copper or other flexible metallic or conductive material. The traces 14 from the various sensors 12 are routed along the flexible material 10 to a tail section 20. The traces 14 extend along the tail section 20 for connection with the occupant detection circuit 22.
The tail section 20 is of any length, such as from a few inches to a yard. In alternative embodiments, the traces 14 terminate at an edge or other location on the film material 10 with or without the tail 20.

The length and origin of the tail section 20 allows for placement of the occupant detection circuit 22 in various locations relative to the sensors 12 or a seat. Other origins or lengths than shown in Figures 1 and 2 may be used.

In one embodiment, the sensors 12 are used by an occupant detection circuit 22 for transmitting and/or receiving data. For example, the sensors 12 are to be distributed at different depths away from an occupant, such as disclosed by U.S. Patents Nos. 6,320,913 and 6,329,914, the disclosures of which are incorporated herein by reference. In one embodiment, the flexible material 10 is folded over at least a portion of a spacer, such as disclosed in U.S. Patent No. (Serial No. 10/996,700), the disclosure of which is incorporated herein be reference. The spacer is a separator of compressible material, such as foam. As another example, the sensors 12 are spaced apart to sense field or capacitance effects of occupants or items at different locations on the seat.

The occupant detection circuit 22 connects or is connectable with the signal traces 14 on the tail section 20. The occupant detection circuit 22 is on a circuit board. The circuit board is a printed circuit board, such as an epoxy and fiber glass laminate. The circuit board is more rigid than the flexible circuit material or flexible film 20. Active and passive components of the occupant detection system 22 are soldered, connected or otherwise formed on the circuit board. Push through or compliant pins connect the traces 14 on the flexible material 10 with electrical traces and components on the circuit board. Alternatively, bonding, wire bonds or other connections are used. In alternative embodiments, a portion or the entirety of the occupant detection circuit 22 is formed as a flexible circuit on the flexible film 10.

For capacitance, electric field or other types of occupant detection using transmission of energy, the sensors 12 may have a desired area and/or shape. For example, the three sensors 12 shown in Figure 1 have about 11,000-12,100 square millimeters. Larger or smaller sizes may be provided. The difference in area for different sensors 12 may be larger, such as one or more sensors 12 having a substantially smaller or larger area than another sensor 12.

The flexible circuit material 10 includes the apertures 11A-C. The apertures 11A-C are holes in or through the film material. The apertures 11A-C are cut, punched, stamped, molded, formed or otherwise created in the flexible circuit material 10.

Some of the apertures 11A-B are each smaller in area than an antenna area of each of antennas. The area of the holes is less than the area of one of or each of the antennas. For example, each aperture 11A-B is less than half or less than one-tenth the area of one of or each of the sensors 12. Apertures 11A-B with a same area or different area may be used. For example, even apertures of a same type 11A, 11B or 11C may have different areas. The apertures 11A adjacent to but not through the sensors 12 have a same area, but may vary in size. The apertures 11B through the sensors 12 have two different areas, but may have only one or more than two different areas.

One type of apertures 11A is adjacent to but not through one of the sensors 12. A plurality of the apertures 11A extends along two edges of the sensor 12, but may be along only one edge, a partial edge, or more than two edges. Another type of aperture 11B is through the sensors 12. This other type of apertures 11B may be spaced linearly along one dimension as shown in Figure 1, but other arrangements are possible. For example, the apertures 11B are along one or more edges of the sensor 12. As another example, a two-dimensional repeating or non-repeating pattern is provided. Figure 1 shows using both types of apertures 11A and 11B. In alternative embodiments, only one type or additional types of apertures are provided.

The apertures 11A-C may be of any shape. One type of aperture 11A-C may be of a same shape or a plurality of different shapes. For example, the small area apertures 11A adjacent to the sensors 12 but not through the sensors 12 are all a same shape, but may include apertures of two or more shapes. As another example, the apertures 11B through the sensors 12 have two different shapes, but may include additional or fewer different shapes. Any shape may be used, such as circular (see apertures 11A), ellipsoidal (see apertures 11B), rectangular (see apertures 11B), square, or any other curved shape, straight edged shape or combinations thereof. The apertures 11A-C may be generally a particular shape, such as the shape with some deviation from true or mathematically ideal (e.g., a "football" shape being generally ellipsoidal).

The third type of apertures 11C is positioned between the sensors 12. The third type of apertures 11C may be larger, the same or smaller than the other apertures 11A-B and/or the sensors 12. For example, the third type of apertures 11C includes holes having an area substantially same or greater than the area of one or more of the sensors 12. The third type of aperture 11C may be provided to allow "breathing" or airflow through the foam for occupant comfort. The third type of aperture 11C removes unneeded or undesired film material not supporting the sensors 12 and/or other apertures (e.g., 11A) for noise reduction.

The occupant detection circuit 22 is a processor, amplifier, filter, applications specific integrated circuit, field programmable gate array, digital component, analog component, combinations thereof or other now known or later developed devices for determining a presence or characteristic of an occupant. For example, the occupant detection circuit 22 determines resistance, current or voltage associated with a pressure sensor. As another example, the occupant detection circuit 22 uses pattern recognition or other processes for optical, acoustic or infrared sensing. In yet another example, one of the occupant detection circuits disclosed in U.S. Patent Nos. 5,406,627, 5,948,031, 6,161,070, 6,329,913, 6,329,914, 6,816,077, and 6,696,948, the disclosures of which are incorporated herein by reference, is used. The effect of an occupant on an electric field is used to determine the presence or other characteristic of an occupant, such as a human or an inanimate occupant. The loading current or other values associated with the transmission of radio frequency waves are used to determine the occupant information. Alternatively, the transmission from one sensor 12 and reception at other sensors 12 is used. Other electric field or capacitive sensing circuits may be used, such as a circuit for determining a capacitance, a frequency change, current level, voltage level or other characteristic of an occupant effect on an electric field or a capacitance value.

Additional components may be formed on or connected to the flexible material 10. For example and as shown in Figure 1, a temperature, humidity or both temperature and humidity sensor are connected with the flexible material 10. In one embodiment, one of the additional sensors disclosed in U.S. Patent No. 6,816,077 is provided. In one embodiment, an aperture is formed in the flexible material 10 for positioning of a printed circuit board or discrete sensor components for connections with a trace or traces 14 on the flexible material 10. The connection is spaced from the tail 20 or the occupant detection circuit 22. The trace 14 extends from the additional sensor to the occupant detection circuit 22. In alternative embodiments, the additional sensor or sensors are formed on the flexible film 10, such as forming a flexible circuit.

Figure 2 shows the positioning of the sensor system in a seat 30. For example, the seat 30 is a passenger, driver, bench, bucket or other seat of a vehicle. The flexible film 10 is positioned at least part within the vehicle seat. For example, the flexible circuit material is between the fabric and foam in a base portion 34 with or without any intervening material. The flexible film 10 is bonded to the foam, fabric or both. Alternatively, the flexible film 10 rests on but is not connected to other materials. In yet other alternatives, the film 10 is stitched to or otherwise connected to other seat material. As shown in Figure 2, the flexible film 10 is positioned on a top of the base portion 34, but may alternatively be positioned between multiple layers of foam or other base portion seat materials. For the film 10 of Figure 1, the sensor 12 closest to the tail 20 rests on or by the bite line of the base portion (e.g., close to the back of the base portion 34 but in front of the top portion 32). In alternative embodiments, the flexible film 10 is positioned within or adjacent to a top portion 32, both the base portion 34 and top portion 32 or spaced from the seat 30, such as in a headliner or dashboard.

The tail section 20 allows placement of the occupant detection circuit 22 in various locations relative to the sensors 12 and associated flexible film 10. The occupant detection circuit 22 is within a void or other structure formed within the base portion 34. In alternative embodiments, the occupant detection circuit 22 is elsewhere within the vehicle. For an example with fold flat seats, the occupant detection circuit 22 mounts under the front cushion frame 36 or along a side of the base portion 34 or the cushion frame 36. Standard seats may allow a mount to the cushion, cushion frame 36 or within the back section 32, such as between a back frame and back covering. The tail section 20 may extend from the flexible circuit 10 in the desired mounting direction. In one embodiment, the tail section 20 extends through a gap in the stitching connecting the covering fabric to a J-strip or other trim connector for connecting with the occupant detection circuit 22 on the cushion frame 36 beneath the seat 30. The orientation of the occupant detection circuit 22 may avoid folds in the tail section 20. Alternatively, the circuit 22 may be positioned at any of various angles accommodated by the flexibility and folding of the tail section 20. The circuit board or the associated housing is connected with the cushion frame using screws, plastic fasteners, bolts, adhesive, latches, clips, or other now known or later developed structure. The housing or printed circuit board may be bonded, stitched or otherwise attached to textile covering or foam of the seat 30.

Further cabling, wireless connection or other communications paths are provided for transmitting or receiving information from or to the occupant detection circuit 22 to another processor, device or system. For example, the occupant detection circuit 22 is operable to transmit information along a cable to an air bag system spaced away from the seat 30. Alternatively, the occupant detection circuit 22 includes the air bag system controller. For example, the occupant detection system 22 detects movement of the occupant to sense a crash or includes a separate crash sensor within the seat 30, or spaced from the seat 30. The occupant detection circuit 22 determines whether or not to activate air bag deployment.

Figure 3 shows one embodiment of a method for noise reduction of film material in a seat for occupant detection. The method is implemented using the sensor system, flexible film 10 and arrangement shown in Figures 1 or 2 in one embodiment. In other embodiments, a different flexible materials, configurations or arrangements of components are used. Different, additional or fewer acts may be provided.

In act 52, a plurality of through holes is provided in film material. A conductive area is also provided on the film material. The conductive area is an antenna, electrode or other sensor component. The conductive area is formed in or on the film material. The through holes each have a hole area less than half the conductive area, but other relative sizes may be provided. Other larger or smaller through holes may be provided. Any arrangement of type, position, size, shape or combinations thereof may be used.

In act 54, the film material is positioned adjacent to foam material. Other compressible or flexible material may be used rather than foam material. The film material is connected with, such as pressure bonded, or sets without connection on the foam material. By positioning the film material immediately against the foam material, the compressible foam material extends into at least some of the through holes in response to pressure applied to at least one location on the film material. The expansion of the foam material into one or more holes acts to hold the film material, reducing the likelihood of creasing, popping or buckling of the film material as the pressure changes.

The flexible film is positioned for occupancy sensing. For example, flexible circuit material is positioned at least in part within a vehicle seat. Within the vehicle seat includes positioned on an outer surface, positioned underneath a textile but over foam, positioned within the foam, positioned below the foam and above a frame, or positioned below the frame of a seat. The sensors are positioned in the base portion, the back portion or both to base and back portions of the seat. Other positions may be used for detecting a seating, standing or other position of occupants of a vehicle, a room or other location. A same flexible film may be used with separate sensors for multiple seats or different films used for different seats or portions of a same seat.

In act 56, the film material is covered. Any covering material may be used, such as additional foam, shielding electrodes, or dielectric material. In one embodiment, the film material is covered with seat covering material, such as fabric, leather or other now known or later developed seat-covering material. The cover may protect the film material from items or occupants.

The flexible film is connected with an occupant detection circuit. For example, flexible circuit material is connected with a more rigid circuit board.
The flexible circuit material is connected to the circuit board using bonding, clips, pins, soldering, pressure, connectors, combinations thereof or other now known or later developed connection technique. One or more antennas and associated signal traces are provided on the flexible circuit material. The flexible circuit material is otherwise free of active and/or passive circuit components. Where multiple antennas or other sensors are provided on the flexible circuit material, the plurality of antennas is connected with separate traces to the occupant detection circuit. Alternatively, one or more of the traces are connected together to provide a larger or combined sensor. The occupant detection circuit is formed on the circuit board. Alternatively, the occupant detection circuit is formed on the flexible circuit material. The flexible circuit material is connected with the occupant detection circuit by patterning, etching or formation of the traces and associated circuitry.

In act 58, the presence or characteristic of an occupant is sensed with, at least in part, conductive structure on or in the film material. The sensor and occupant detection circuit of the sensor system are used to detect a presence or characteristic of the occupant. For example, an antenna is used to detect the presence or characteristic of an occupant as a function of a capacitance or electric field. An alternating current is applied to a sensor. Current, voltage, capacitance or other characteristic of the transmitting sensor is measured for detecting an occupant. Alternatively or additionally, a current, voltage, capacitance or other characteristic of a different sensor receiving signals responsive to the transmissions are used to detect. The size, weight, position, motion, presence, conductivity, load, pattern or other characteristic may be determined. In another embodiment, the weight or weight pattern is sensed with strain gauges, weight cells, capacitance or other weight sensors with conductors at least partly on or in the film material.

While the invention has been described above by reference to various embodiments, it should be understood that many changes and modifications can be made without departing from the scope of the invention. It is therefore intended that the foregoing detailed description be regarded as illustrative rather than limiting, and that it be understood that it is the following claims, including all equivalents, that are intended to define the spirit and scope of this invention.

## Claims

1. A sensor system for occupant detection, the sensor system comprising:
flexible circuit material having a plurality of apertures;
at least one antenna on the flexible circuit material;
an occupant detection circuit connected with the at least on antenna, the occupant detection circuit operable to detect a presence or characteristic of an occupant in response to transmitted energy.

2. The sensor system of Claim 1 wherein the occupant detection circuit comprises a capacitive or electric field sensing circuit; and
wherein the flexible circuit material comprises a polyester film and the at least one antenna comprises conductive material.

3. The sensor system of Claim 1 wherein the plurality of apertures are each smaller in area than an antenna area of each of the at least one antenna.

4. The sensor system of Claim 1 wherein the at least one antenna comprises two or more antennas each associated with at least one of the plurality of apertures.

5. The sensor system of Claim 1 wherein the plurality of apertures has at least two different shapes.

6. A method for noise reduction of film material in a seat for occupant detection, the method comprising:
providing a plurality of through holes in the film material and a conductive area on the film material;
positioning the film material adjacent to foam material; and
positioning seat-covering material adjacent the film material.

7. The method of Claim 6 wherein the conductive area comprises an antenna;
further comprising
sensing for the presence or characteristic of an occupant with the antenna as a function of electric field or capacitance.

8. The method of Claim 6 wherein the through holes each have a hole area less than half the conductive area.

9. The method of Claim 6 wherein positioning the film material adjacent to the foam material comprises positioning the film material such that the foam material extends into at least some of the through holes in response to pressure applied to at least one location on the film material.
